# EUROPEAN PATENT APPLICATION

(11) **EP 3 062 315 A1**
(43) Date of publication of application: **31.08.2016**
(21) Application number: 14856461.0
(22) Date of filing: 15.10.2014
(51) Int. Cl.: H01B 7/02, B32B 5/18, B32B 9/00, B32B 15/08, C23C 8/12, C23C 26/00, C23C 28/00, H01B 13/00

(54) **COPPER-RESIN COMPOSITE BODY AND METHOD FOR PRODUCING SAME**

(30) Priority: 23.10.2013 JP 2013219711
(71) Applicant: Furukawa Electric Co. Ltd., Tokyo 100-8322 (JP)
(72) Inventor: KIM, Yong Hoon, Tokyo 100-8322 (JP)
(74) Representative: Hermann, Felix
(86) International application number: PCT/JP2014/077409
(87) International publication number: WO 2015/060170

(57) **Abstract**

The present invention relates to a copper-resin composite body and provides the copper-resin composite body which is excellent in adhesive property between copper and resin and is applicable to a continuous production process such as a wire production process. The present invention uses the copper-resin composite body including a metal (3 )made of copper or a copper alloy and resin (7) adhering to the metal (3) via a nanoporous layer (5) formed on a surface of the metal (3). It is preferable that the nanoporous layer (5) contains copper-oxide particles of 5 nm to 500 nm in average particle diameter. Further, a process for producing the copper-resin composite body includes a process for forming a copper-oxide nanoporous layer on the surface of the metal made of copper or the copper alloy by irradiating the surface of the metal with laser and a process for forming resin on the copper-oxide nanoporous layer.

## Description

### [Technical Field]

The present invention relates to a copper-resin composite body used for electronic devices, household electrical appliances, vehicle parts, vehicle-mounted articles, etc. and further relates to a method for producing the copper-resin composite body which is excellent in adhesive property between metal and resin and besides is applicable to a continuous production process such as a wire production process.

### [Background Art]

Under the circumstances where along with the rapid development of various industries such as electronics, automobiles, etc., the diversification and high functionalization of materials are growing, and among these materials, the demand is expanding for a member produced by effectively combining metal and resin which are different in property; the high adhesion between dissimilar materials is becoming more important.

For example, in association with the downsizing and weight saving of the electronics, such a winding wire has come to be required that is smaller and lighter than one currently used for the electronics, and besides can be produced at low cost while preserving performances such as a high electric property, a mechanical property, a long-term thermal resistance, etc. Therefore, the winding wire needs to be wound around a smaller core in the high density and moreover at high speed. In that case, such problems have occurred that an insulating coating of the winding wire was damaged and electric properties of the electronics were deteriorated and further a production yield was lowered. For the above reasons, a higher adhesion between a metal conductor and an insulating resin is demanded.

On the other hand, in the situation where a density growth is demanded also for a circuit wiring pattern in a high-density mounting multilayer printed-wiring board, a flexible printed-wiring board (hereunder, simply referred to as a printed-wiring board in some cases), etc. and then a printed-wiring board with a circuit wiring pattern where a width of the circuit wiring and a spacing between the circuit wirings are fine, so-called a finely patterned printed-wiring board is under demand; although a smooth copper foil not subjected to a roughing treatment is preferred as a copper foil applicable to the fine pattern, there has been, in that case, a problem that it was difficult to enhance stably and fully an adhesive property between the copper foil and a resin base material.

Further, in order to become applicable to a speed-up of an information processing of the electronics, and wireless communication, electronic components are required to enable a high-speed transmission of an electric signal, while the application of the electronic components to a high-frequency substrate is also in progress. In the high-frequency substrate, it must be intended to decrease a transmission loss for the sake of performing the high-speed transmission of the electric signal and hence in addition to a decrease in a dielectric constant of the resin base material, the transmission loss of the circuit wiring acting as a conductor needs to decrease, thus requiring the smooth copper foil to be used. However, though the smooth copper foil was excellent in a transmission property in a high-frequency band, it was difficult to enhance stably and fully the adhesive property between the copper foil and the resin base material.

Furthermore, in a lithium battery, in order to extend an operating life thereof, an active material layer and the copper foil acting as a current collector are required to adhere stably to each other. Therefore, a higher adhesion between a binder resin inside the active material layer and the copper foil is needed.

For the above reasons, the higher adhesion between the metal conductor and the insulating resin is required. However, since in regard to such adhesion between dissimilar materials as that between a metal material and a resin material, the affinity therebetween is low; various methods are attempted when allowing the dissimilar materials like these to adhere to each other.

As a method for improving the adhesion between the metal material and the resin material, there is, e.g., a method for forming a covalent bond between the metal material and the resin material by means of a silane coupling agent (in a nonpatent literature 1). There is, however, a problem that a coating forming performance of the silane coupling agent is poor on a metal surface, and hence internal defects are formed inside the coating of the silane coupling agent.

Further, it is also under study that an interface treatment between metal and resin is carried out by a polycarboxylic-acid-based polymer coupling agent to enhance the adhesive property between the metal material and the resin material (in a nonpatent literature 2). According to this method, a polymer adsorption can be stabilized by a formation of a robust ionic bond between metal and resin. However, the possibility of metallic corrosion due to carboxylic acid is unavoidable.

Further, a method is known in which an interface treatment between metal and resin is carried out by a self-assembly monolayer (SAM) (in a nonpatent literature 3). This method enables a functional group to be imparted on a metal surface by means of the reactivity of alkylthiol. However, since the molecular weight of alkylthiol is comparatively low (a principal chain is an aliphatic group and the number of its carbon atoms is on the order of 2 to 10), the alkylthiol is easy to be subjected to autoagglutination. Further, the interaction between the self-assembly monolayer and resin is weak and hence this method is unsuitable to allow dissimilar materials to adhere to each other.

A proposal has been offered in which the adhesive property between metal and resin was improved by an anchor effect produced by etching a copper surface. This method, however, needs a long treating time to form a metallic compound coating and is unable to adapt to a continuous treatment process such as a production of an insulated wire or a metal band, and therefore is limited only to a batch production process, thus leading to a highly inferior productivity.

With the view to these problems, a method for improving the adhesion between copper and a thermosetting insulating material such as polyamide-imide, polyimide or the like used for the productions of the electronic devices, the household electrical appliances, the vehicle parts, the vehicle-mounted articles, etc., and thereby giving a high degree of the adhesion; or the development of a method for improving the adhesion, which is applicable to continuous processes such as the wire, copper foil and metal band production processes; has been required.

### [Citation List]

### [Nonpatent Literature]

Nonpatent literature 1: H. Yamabe et al. Jpn. Soc. Colour Mater., Viol.70, p.763 (1997)
Nonpatent literature 2: H. Yamabe, W. Funke, Farbe und Lack, Vol. 96, p.497 (1990)
Nonpatent literature 3: M. Stratmann, Adv. Mater., Vol. 2, p.191 (1996)

### [Summary of Invention]

### [Technical Problem]

It is an object of the present invention to provide a method for improving adhesion between copper and a thermosetting insulating material such as polyamide-imide, polyimide, etc. and thereby giving a high degree of the adhesion; and further provide a copper-resin composite body which is excellent in adhesive property between copper and resin and is applicable to a continuous production process such as a wire production process in regard to the copper-resin composite body used for electronic devices, household electrical appliances, vehicle parts, vehicle-mounted articles, etc.

### [Solution to Problem]

In order to attain the above-mentioned object, the following inventions are provided.
(1) A copper-resin composite body characterized in that a metal made of copper or a copper alloy and resin adhering to the above metal via a nanoporous layer formed on the metal are included therein.
(2) The copper-resin composite body according to (1), characterized in that the above nanoporous layer contains copper-oxide particles of 5 nm to 500 nm in average particle diameter.
(3) The copper-resin composite body according to (1) or (2), characterized in that the above resin is a thermosetting resin containing at least one selected from a group including polyimide, polyamide-imide, polyesterimide, polyetherimide, polyimide hydantoin-modified polyester, formal, polyurethane, polyester, polyvinylformal, epoxy resin, phenol resin, and polyhydantoin.
(4) The copper-resin composite body according to any one of (1) to (3), characterized in that a ten-point average roughness Rz of the above metal is 20 µm or less in an interface between the above metal and the above resin.
(5) The copper-resin composite body according to any one of (1) to (4), characterized in that cavities of 10 nm to 500 nm in diameter are included in the vicinity of a surface of the above metal in the interface between the above metal and the above resin.
(6) The copper-resin composite body according to any one of (1) to (5), characterized in that the copper-resin composite body is any one of an insulated copper wire, a flat cable, a surface-treated copper foil, a copper-clad laminate, a battery electrode, and a surface-treated copper band.
(7) A method for producing a copper-resin composite body, characterized in that a process for forming a copper-oxide nanoporous layer on a surface of a metal made of copper or a copper alloy by irradiating the surface of the metal with laser and a process for forming resin on the above copper-oxide nanoporous layer are included therein.

### [Advantageous Effects of Invention]

The present invention relates to the copper-resin composite body and is able to enhance the adhesive property between copper and resin and besides is able to provide the copper-resin composite body applicable to the continuous production process such as the wire production process, etc.

### [Brief Description of Drawings]

Fig. 1 is a cross-sectional view illustrating copper-resin composite bodies 1, 1a according to an embodiment of the present invention.
Fig. 2 is a flowchart illustrating a process for producing the copper-resin composite body according to the embodiment of the present invention.
Fig. 3 is a cross-sectional view illustrating an insulated copper wire 11 according to an embodiment of the present invention.
Fig. 4 is a cross-sectional view illustrating a flat cable 21 according to an embodiment of the present invention.
Fig. 5 is an enlarged view of an A portion in Fig. 4.
Fig. 6 is an explanatory drawing of beam spot positions when applying a laser processing to part of a surface of a metal.
Fig. 7(a) is a scanning electron micrograph of a surface of copper after applying a laser surface treatment according to an embodiment 1 and Fig. 7(b) is an enlarged microgram of Fig. 7(a).
Fig. 8 is a cross-sectional photograph of an interface between copper and polyamide-imide resin according to the embodiment 1, and α indicates a nanoporous layer in Fig. 8.
Fig. 9 is a cross-sectional photograph of the interface between copper and polyamide-imide resin according to the embodiment 1, and α indicates the nanoporous layer in Fig. 9.

### [Description of Embodiments]

Hereunder is a detailed description of embodiments according to the present invention based on the drawings.

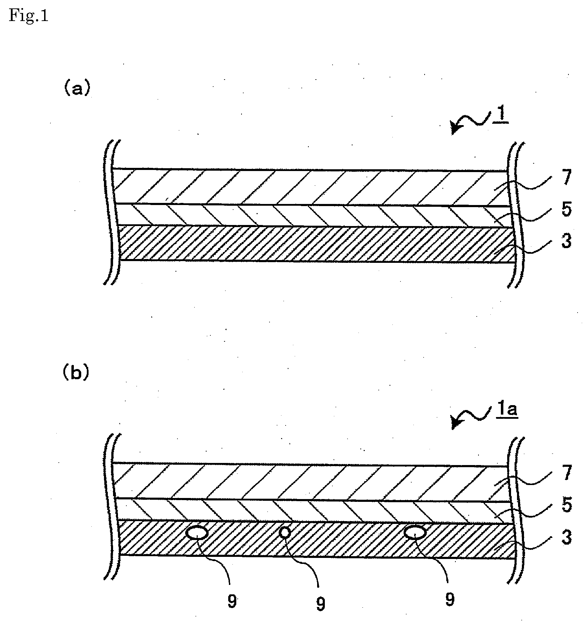

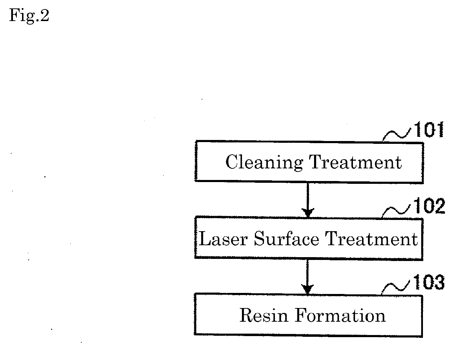

As shown in (a) in Fig.1, a copper-resin composite body 1 includes a metal 3, and resin 7 provided on a nanoporous layer 5 provided on a surface of the metal 3. The metal 3 is made of copper or a copper alloy. The nanoporous layer 5 is a copper-oxide nanoporous layer containing copper-oxide nanoparticles. Further, as the resin 7, a resin having an insulation property is preferable and further thermosetting resin is preferable depending on its purpose of use. The copper-resin composite body 1 is, as shown in Fig. 2, formed mainly by three processes including a cleaning treatment process 101, a laser surface treatment process 102, and a resin formation process 103. Each process is explained below.

### <Cleaning Treatment>

In some cases, the surface of the metal 3 made of copper or a copper alloy becomes uneven due to segregation and an oxide layer which are caused in production processes, and is contaminated due to the adherence of rolling-mill lubricant, machining oil, press oil, etc. used in machining and forming, the generation of rust, the attachment of finger patterns in carrying the metal 3, etc.. Accordingly, a cleaning treatment is preferably performed using an appropriate cleaning method depending on a condition of the surface of the metal 3. However, since the contaminants are removed by a laser processing, applied to the surface of copper, which is to be carried out in the following process, the cleaning treatment of the surface of the metal prior to the laser processing is judged to be optional.

As the cleaning method, physical methods including grinding, buffing, shot blast or the like, an electrochemical method where an electrolytic process is practiced in, e.g., an alkaline degreasing solution and the cleaning is performed utilizing hydrogen and oxygen which are generated, and a chemical method by an alkaline solvent medium (detergent) are cited, and thereafter a posttreatment is preferably implemented by acidic liquid as a neutralizing process. Besides, a dry processing such as a UV-ozonization processing and a plasma processing can be also used.

### <Laser Surface Treatment >

A laser metal surface treatment used in the present invention is based on a laser ablation technique. The laser ablation means a process in which when irradiating solid matter with laser light, if the irradiation intensity of the laser light exceeds a certain level (threshold), the laser light is converted into electronic, thermal, photochemical and dynamic (mechanical) energies on a surface of the solid matter and as a result, neutral atoms, molecules, positive and negative ions, radicals, clusters, electrons, and light (photons) are explosively released to etch the surface of solid matter. Specifically, when irradiating the surface of the metal with the laser light, the laser light is absorbed by the solid matter, free electrons, ions and atoms are released via various elementary steps. The particles thus released absorb the laser light to produce high-temperature plasma and release a large amount of particles from the solid matter. A group of these particles are scattered by free expansion if an ambient atmosphere is vacuum, while if the ambient atmosphere is gaseous, the group of these particles expand while repeating collision and reaction. Some of the released particles interact with an atmospheric gas and as a result, attach again to the ablated surface of the solid matter. These residua are referred to as debris and have become a major issue as contaminants in the fine processing of the surface of the solid matter (cited from a book of "Laser Ablation and its Applications" edited by Investigating R&D Committee on Industrial Applications of Laser Ablation in the Institute of Electrical Engineers, published by CORONA PUBLISHING CO., LTD. in 1999).

The present invention is characterized in that re-adhered particles that have been conventionally the issue of the laser ablation are utilized to form, on the surface of copper, a nanoporous layer containing copper-oxide nanoparticles and thereby remarkably improve the adhesive property between metal and resin.

A mechanism of the improvement in the adhesive property between metal and resin can be considered as described below. The nanoparticles ejected during the laser ablation re-adhere to a surface and then a porous layer containing these nanoparticles is formed on the surface. When coating liquid thermosetting resin on the surface, the resin gains entrance into nanospaces of the nanoporous layer with no space left in the nanoporous layer. Afterward, when baking the resin, innumerable nanoscale anchors are formed in the interface between metal and resin and thereby the adhesive property is remarkably improved.

In the laser processing, in order to make the nanoparticles easy to re-adhere, the pressure of the atmosphere is preferably increased and therefore the laser processing is preferably performed within the atmosphere of a high-density gas such as the atmospheric air or argon.

### <Nanoporous Layer>

The thickness of the nanoporous layer formed on the surface of the metal by the re-adhering of the nanoparticles is not particularly limited. However, a 5 nm to 3,000 nm thick nanoporous layer is recommendable and further the nanoporous layer is preferably 10 nm or more and 2,000 nm or less in thickness, and is furthermore preferably 10 nm or more and 1,000 nm or less in thickness. Thickness of 5 nm or less makes it impossible to expect the effect of the present invention, while in order to form a 3,000 nm or more thick nanoporous layer, a long laser surface treatment is required to make it difficult to perform a continuous treatment process and besides even if the nanoporous layer becomes 3,000 nm or more in thickness, it is considered that an anchor effect is unlikely to increase. Further, in consideration of the fact that the deterioration of the resin becomes prone to progress by a catalytic effect of copper, it is unfavorable to form the 3,000 nm or more thick nanoporous layer.

Furthermore, the average particle diameter of the copper-oxide nanoparticle which re-adheres is 5 to 500 nm, and is preferably 10 to 300 nm, and is more preferably about 10 to 100 nm, and is furthermore preferably 20 to 50 nm. The nanoporous layer is mainly made up of the copper-oxide nanoparticles having average particle diameters of 5 to 500 nm. In the nanoporous layer, however, particles other than the copper-oxide nanoparticles having average particle diameters of 5 to 100 nm are likely to get mixed in the nanoporous layer as impurity and by-product. It is preferable that among particles making up the nanoporous layer, 50 % or more of particles in number and preferably 80 % or more of particles in number are the copper-oxide nanoparticles of 5 to 500 nm in average particle diameter. Besides, the particles are not densely stacked and adhere together with air gaps left and hence in some cases, holes three-dimensionally communicating with one another are formed in the nanoporous layer.

### <Nanosized Cavity Formation in the Vicinity of Surface>

Fig. 1(b) shows a cross-sectional view of the copper-resin composite body 1a including nanosized cavities in the vicinity of the surface of the metal. A size of the cavity formed in the vicinity of the surface of the metal by the laser surface treatment is not particularly limited. The size of the cavity is, however, preferably 10 nm or more and 500 nm or less, and is particularly preferably 10 nm or more and 300 nm or less. If the size of the cavity exceeds 500 nm, the cavity is able to act as a defect to cause a decrease of the adhesive property. Further, the vicinity of the surface where the cavities are formed means a depth within 1 µm from the uppermost surface of the metal except the nanoporous layer 5.

The reason for the formation of the cavities caused by the laser processing is not unclear. As part of the reason, however, it can be understood that the surface of the metal where the cavities are generated by radiating laser to the surface of the metal is instantly solidified.

### <Condition of Laser Surface Treatment>

The laser light used for the laser surface treatment is not particularly limited. However, gas laser such as excimer laser used for laser ablation, CO₂ laser, etc., solid-state laser such as YAG, etc., and fiber laser are preferable. The solid-state laser and the fiber laser are more preferable since it is effective to use a short pulse light by which a high peak output can be obtained by concentrating energy within a shorter time length. As the short pulse light, it is effective to use nanosecond to femtosecond pulse lights and further it is more effective to use picosecond to femtosecond pulse lights.

When irradiating solid matter with laser light, the irradiation intensity of the laser light needs to become more than a certain value (threshold) in order to release particles, and as its parameter, a laser light intensity (an energy quantity per unit area and per unit time) needs to be controlled and therefore it is preferable that the intensity is, e.g., 10⁹ W/cm² or more. When intensifying further the laser light intensity, a surface machining speed of laser increases to become preferable for the continuous process and therefore the intensity is preferably 10¹⁰ W/cm² or more and is further the intensity is more preferably 10¹¹ W/cm² or more.

If the laser light intensity is too high, however, the laser ablation makes excessive progress and thereby the macroscale unevenness on the surface of the metal becomes large, so that the unevenness of 10 µm to 50 µm is formed on the surface of the metal. If the unevenness becomes large, when the liquid thermosetting resin is coated on the surface of the metal, the air within the unevenness does not sufficiently get out and as a result, a large number of air bubbles are caused to arise in a baking treatment.

Further, if a machining speed per unit area (mm²/sec), which is controllable by a laser scanning speed, decreases, the unevenness becomes large by the progress of ablation and further the continuous working process becomes difficult, and thereby the machining speed is preferably 10 mm²/sec or more and further is more preferably 50 mm²/sec or more.

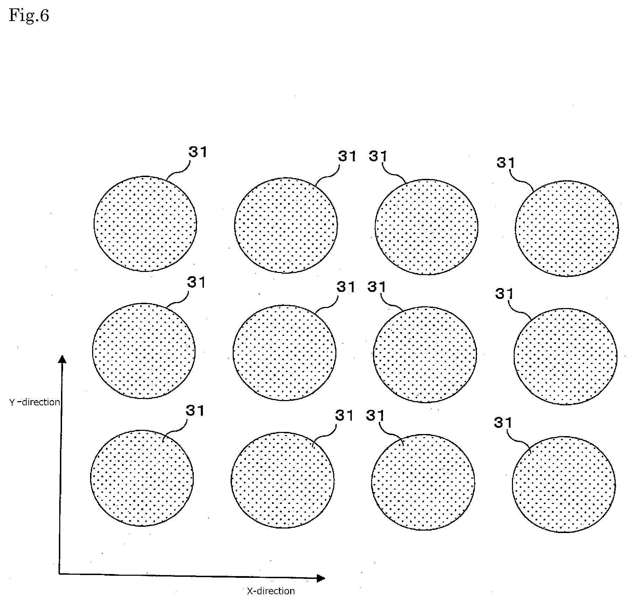

Furthermore, as a laser scanning method, other than a method for carrying out a scanning operation at a constant speed to irradiate a whole surface of the metal with laser, such a method is also possible that laser is radiated to only part of the metal for the purpose of increasing the laser machining speed. As a method for radiating laser only to part of a sample, e.g., a method for radiating laser in any one of a longitudinal direction (X) and a direction (Y) vertical to the longitudinal direction or a method for radiating laser in both the X and Y directions at regular intervals as shown in Fig. 6 are cited. When irradiating the surface of the metal with laser, the nanoparticles are scattered up to a peripheral area of a beam spot to form the nanoporous layer containing the nanoparticles and hence even when laser is radiated only to part of the surface of the metal, the improvement effect in adhesion can be expected.

Then, whilst not exclusively, in consideration of a resin viscosity, a standing time elapsing from resin coating to the baking treatment, etc., and by controlling the above laser light intensity and laser machining speed, an unevenness level (the ten-point average roughness Rz) is preferably regulated so as to become, e.g., 20 µm or less, more preferably 10 µm or less, and furthermore preferably 5 µm or less. In the copper material subjected to the laser surface treatment according to the present invention, even if the unevenness is 5 µm or less, an extremely high adhesive property between the copper material and the thermosetting resin can be obtained by a nano-anchor effect derived from the nanoporous layer formed on the surface. Therefore it can be said that the present invention is an exceedingly effective method for improving the adhesive property between a metal and the thermosetting resin. Further, as described above, if the unevenness is overlarge, the air within the unevenness does not sufficiently get out when the liquid thermosetting resin is coated on the surface of the metal and as a result, the large number of air bubbles is caused to arise in performing the baking treatment.

As a method for verifying macroscopically the unevenness level of the surface of the metal, which is formed by the laser processing, e.g., an analyzing method by a laser microscope is cited. Further, as a method for performing micro-level detailed observation, the interface between metal and resin can be verified by a scanning electron microscope (SEM) after processing the cross-section by means of an Ar-ion milling method.

In addition, the ten-point average roughness Rz determines a sum of an average value of five peak values obtained from the highest peak value to fifth-highest peak value and average value of five depth values obtained from the deepest valley depth value to the fifth-deepest valley depth value, in a roughness curve of a reference length. Therefore, the ten-point average roughness Rz does not reflect a nano-level fine unevenness formed by the nanoparticles making up the nanoporous layer but reflects a macro-level unevenness. Accordingly, the ten-point average roughness Rz is not particularly changed by the presence or absence of the nanoporous layer and hence even after the nanoporous layer is formed, the macro-level unevenness on the surface can be evaluated.

### <Resin Formation >

In the present invention, the resin having thermal resistance and further an insulation property depending on its intended use is preferable as the thermosetting resin used for a resin material. For example, such resins are usable as polyimide, polyamide-imide, polyesterimide, polyimide hydantoin-modified polyester, formal, polyurethane, polyester, polyvinylformal, epoxy resin, phenol resin, and polyhydantoin. Preferably, polyimide-based resin such as polyimide, polyamideimide, polyetherimide, polyesterimide, polyetherimide, and polyimide hydantoin-modified polyester which are excellent in thermal resistance can be used. In addition, among these resins, one resin may be used and further two or more resins may be mixed to be used.

Further, the same improvement in adhesive property can be expected also for liquid resin such as UV-curing resin, etc.

### <Insulated Copper Wire>

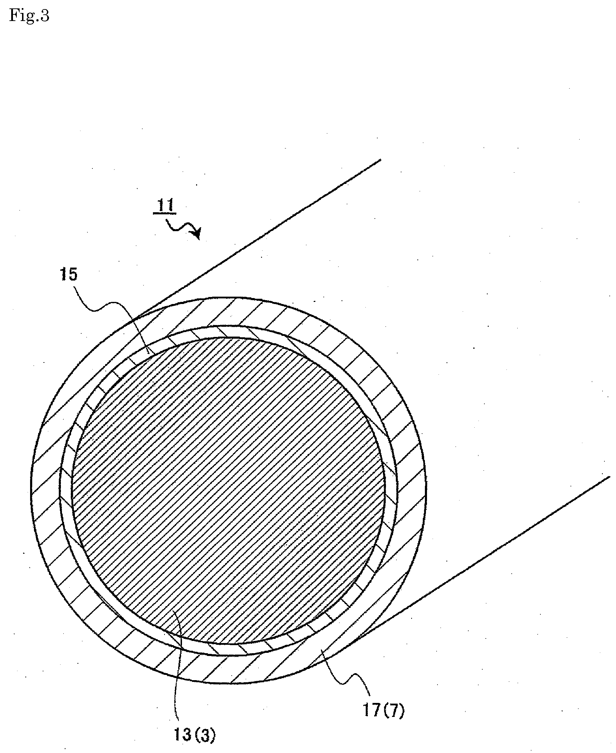

The copper-resin composite body according to the embodiment of the present invention can be used for an interface between metal and resin in an insulated copper wire. As shown in Fig. 3, the insulated copper wire 11 includes a metal wire 13 made of copper or a copper alloy and an insulating coating 17 for coating the metal wire 13 via a nanoporous layer 15 formed on a surface of the metal wire 13. Specifically, in an interface between the metal wire 13 and the insulating coating 17, the insulated copper wire 11 has a stacked structure composed of the metal 3, the nanoporous layer 5, and the resin 7 which are the same as those of the copper-resin composite body 1 according to the embodiment of the present invention. The metal wire 13 corresponds to the metal 3, the nanoporous layer 15 does to the nanoporous layer 5, and the insulating coating 17 does to the resin 7, and thus the same materials can be used. By winding the insulated copper wire 11 like this, a coil can be made. Since being excellent in the adhesive property between the metal wire 13 and the insulating coating 17, the insulated copper wire 11 can be wound with high tension and at a high rotating speed to enable a high-winding-density coil to be obtained with high productivity.

### <Flat Cable>

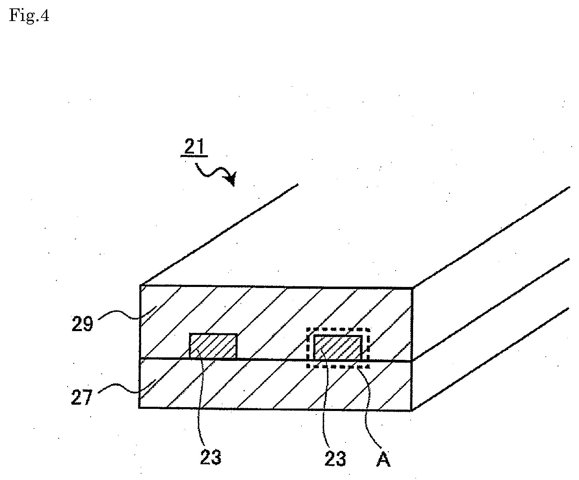

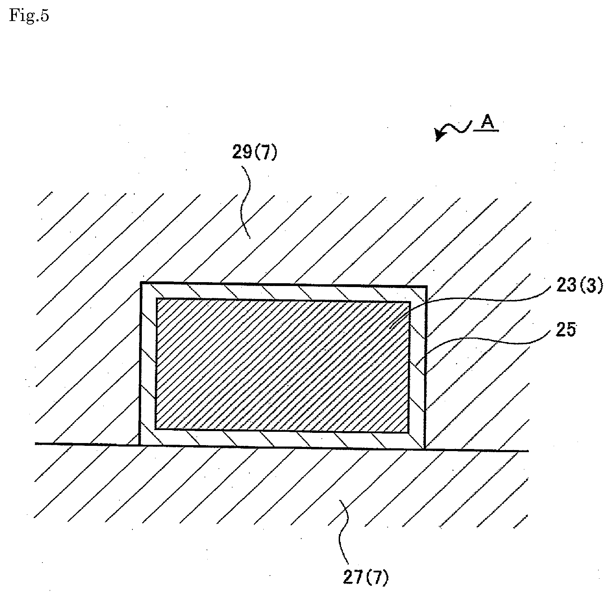

The copper-resin composite body according to the embodiment of the present invention can be used for an interface between metal and resin in a flat cable. As shown in Fig. 4, the flat cable 21 has a structure where each of conductors 23, made of copper or a copper alloy, is sandwiched by a resin layer 27 and a resin layer 29 from both sides of each of the conductors. Fig. 5 is an enlarged view of a portion A in Fig. 4. As shown in Fig. 5, the flat cable 21 includes the conductors 23 made of copper or a copper alloy and the resin layers 27, 29 for sandwiching the conductors 23 from both the sides thereof via a nanoporous layer 25 formed on a surface of each of the conductors 23. Specifically, in an interface between the conductor 23 and the resin 27 or the resin 29, the flat cable 21 has the stacked structure composed of the metal 3, the nanoporous layer 5, and the resin 7 which are the same as those of the copper-resin composite body 1 according to the embodiment of the present invention. The conductor 23 corresponds to the metal 3, the nanoporous layer 25 does to the nanoporous layer 5, and each of the resin layers 27, 29 does to the resin layer 7, and thus the same materials can be used. The flat cable 21 like this can be used for interconnecting wires of an electric machine, an automobile, etc. The flat cable 21 is excellent in the adhesive property between the conductors 23 and the resin layers 27, 29 and therefore even if repeating a bending action thereof, the peelings between the conductors 23 and the resin layers 27, 29 does not occur.

### <Copper-Clad Laminate>

The copper-resin composite body according to the embodiment of the present invention can be used for an interface between a metal in a copper-clad laminate plate and resin. The copper-clad laminate according to an embodiment of the present invention has a structure where a metal foil made of copper or a copper alloy is adhered to, via a nanoporous layer, one surface or both surfaces of prepreg on whose outer surface a resin layer is formed. The prepreg can be obtained by impregnating thermosetting resin into a fibriform reinforcing material such as glass fiber and carbon fiber, and heating or drying the impregnated material to be made half-hard. Specifically, in an interface between the metal foil and the resin layer of the prepreg, this copper-clad laminate has a laminate structure composed of the metal 3, the nanoporous layer 5, and the resin 7 which are the same as those of the copper-resin composite body 1 according to the embodiment of the present invention. This copper-clad laminate enables a width of a circuit wire and a spacing between the circuit wires to be fine since the copper-clad laminate enables a sufficiently adhesive strength to be obtained even if using a smooth metal foil not subjected to a roughening process intended to increase the ten-point average roughness Rz.

### <Surface-Treated Copper Foil>

The copper-resin composite body according to the embodiment of the present invention can be used for an interface between metal and resin in a surface-treated copper foil. The surface-treated copper foil according to the embodiment of the present invention includes a metal foil made of copper or a copper alloy and a resin layer adhering to the metal via a nanoporous layer formed on a surface of the metal foil. Specifically, in an interface between the metal foil and the resin layer acting as a surface-treated layer, this surface-treated copper foil has the stacked structure composed of the metal 3, the nanoporous layer 5, and the resin 7 which are the same as those of the copper-resin composite body 1 according to the embodiment of the present invention. Accordingly, an adhesive strength between the resin layer and the metal foil is 2,000 N/m or more, thus leading to an excellent adhesive property. Further, since a smooth metal foil can be used, the surface-treated copper foil according to the present invention is excellent in transmission property in a high-frequency zone.

### < Battery Electrode >

The copper-resin composite body according to the embodiment of the present invention can be used for an interface between metal and resin in a battery electrode. The battery electrode according to the embodiment of the present invention includes the metal foil made of copper or a copper alloy and an active material layer adhering to the metal via a nanoporous layer formed on the surface of the metal foil. Specifically, in an interface between the metal foil and the active material layer containing a binder made of resin, this battery electrode has the stacked structure composed of the metal 3, the nanoporous layer 5, and the resin 7 which are the same as those of the copper-resin composite body 1 according to the embodiment of the present invention. Especially, in a negative electrode used for a lithium-ion secondary battery including the copper-resin composite body 1 according to the embodiment of the present invention in the interface between the metal foil and the active material layer, the active material layer and the copper foil acting as a current collector are adhered stably to each other and therefore even if such a prominently-expandable/contractable silicon-based active material is used for the active material of the negative electrode, an excellent cyclic property can be obtained.

### <Surface-Treated Copper Band>

The copper-resin composite body according to the embodiment of the present invention can be used for an interface between a metal in a surface-treated copper band and resin. The surface-treated copper band according to the embodiment of the present invention includes a metal band made of copper or a copper alloy and a resin layer adhering to the metal band via a nanoporous layer formed on a surface of the metal band. Specifically, in an interface between the metal band and the resin layer acting as a surface treated layer, this surface-treated copper band has the stacked structure composed of the metal 3, the nanoporous layer 5, and the resin 7 which are the same as those of the copper-resin composite body 1 according to the embodiment of the present invention. Therefore, the adhesive strength between the resin layer and the metal band reaches 2,000 N/m or more, thus leading to an excellent adhesive property.

<Effects according to the Present Embodiment>

The mechanism of the improvement in the adhesive property between metal and resin is that the nanoparticles ejected during the laser ablation re-adhere to the surface of the metal and at the time, the nanoporous layer containing these nanoparticles is formed on the surface. Besides, it is considered that when the liquid thermosetting resin is coated on the nanoporous layer, the thermosetting resin gains entrance into nanospaces in the nanoporous layer with no space left therein and afterward when applying the baking treatment, nanoscale innumerable anchors are formed in the interface between metal and resin and thereby the adhesive force between the metal 3 and the resin 7 is remarkably improved.

Further, the process for producing the copper-resin composite body in the present embodiment can be completed in a shorter amount of time as compared with the time conventionally taken and therefore is applicable to the continuous production process such as a wire production process.

### EMBODIMENTS

Next is a detailed description on embodiments and comparative examples for the sake of further clarifying the effects of the present invention. The present invention is, however, not limited to these embodiments.

### <Embodiment 1>

### 1. Copper Surface Treatment

Pure copper (thickness=200 µm, size=3 mm×120 mm) was used and the surface treatment was done in the following order.

### 1-1. Cleaning Treatment using UV Ozone Generator

As a cleaning treatment method prior to the laser processing, the cleaning treatment was performed for 3 minutes using a UV ozone generator (made by SEN LIGHTS CORPORATION, PL17-110, UV lump=189.9 nm, 253.7 nm).

### 1-2. Laser Surface Treatment

Using a solid-state laser system (YAG pulse laser, central wavelength=515 nm, pulse width=0.9 psec) made by Hamamatsu Photonics K.K., the laser processing in the atmosphere was performed under the condition that pulse energy: 90 µJ, a pulse repetition frequency: 20 kHz, a beam spot size: 66 µm, a laser light intensity: 2.9×10¹² W/cm², a laser scanning speed: 1 mm/sec in the longitudinal direction (X) and 800 mm/sec in the direction (Y) vertical to the longitudinal direction (X), and a machining speed: 800 mm²/sec.

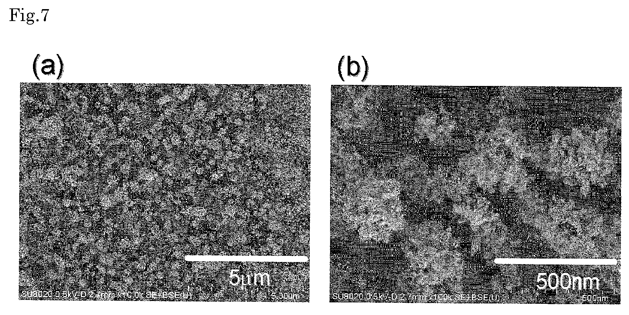

As a result, as shown in Fig. 7(a), the formation of a fine unevenness could be verified by an electronic microscope and thus it was learnt in an enlarged photograph shown in Fig. 7(b) that a nanoporous layer, which was made up of the copper-oxide particles of about 50 nm and included holes three-dimensionally communicating with one another, was formed on the surface.

In order to verify a micro-level surface unevenness, using a laser microscope (VK-X200 made by KEYENCE Corporation), a lens of 150 magnifications and further using an observed photography of the surface of the metal and an image analysis application (Ver. 3.2.0.0 made by KEYENCE Corporation), a value of the ten-point average roughness Rz was measured.

### 2. Resin Formation on Surface of Copper

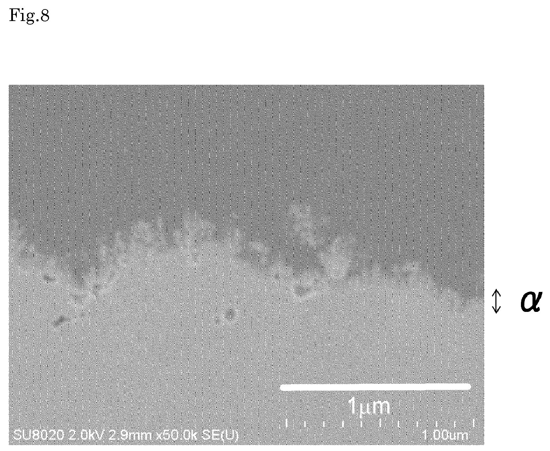

Using a coater, polyamideimide (PAI, HI406SA) resin was uniformly coated (resin thickness=about 30 µm) on the surface of copper treated as described above. Afterward, thermal treatments were performed at 150 degrees C, 200 degrees C and 250 degrees C for 20 minutes for each of the temperatures, and the baking treatment was applied to the resin on the surface of the metal. As a result, as shown in a cross-sectional photograph of a resin-coated and laser-processed copper sample (the copper-resin composite body) shown in Fig. 8, such an aspect could be verified that the resin gained entrance into a nanoporous layer α (in Fig.8) made up of nanoparticles of about 50 µm with no space therein. On the other hand, it was verified that the cavities of about 100 nm were formed in the vicinity of the surface of the metal.

### <Embodiment 2>

A test piece was made in the same fashion as in the embodiment 1 except that the laser processing condition was changed into one where the beam spot size: 300 µm and the laser light intensity: 5.7×10¹¹ W/cm².

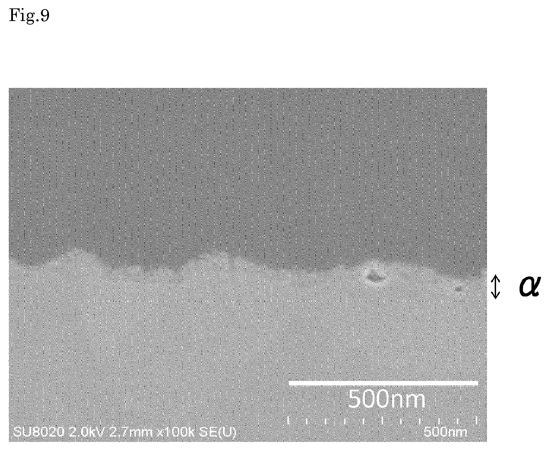

Fig. 9 shows a cross-sectional photograph of an interface between copper and polyamide-imide resin according to an embodiment 2. In the embodiment 2, since the laser intensity was low and the beam spot was large, an energy quantity applied to a unit area was small and thereby the nanoporous layer α (in Fig. 9) became thin. Besides, it was verified that cavities on the order of 10 to 50 nm in diameter were formed in the vicinity of the surface of the copper foil. As shown in a table 1 described hereinafter, the adhesive force in the embodiment 2 was higher than that in the comparative example 1 and irrespective of the thin nanoporous layer, the improvement effect in the adhesive force was verified. In the embodiment 2, it is considered that since Rz is smaller than that in the comparative example 1, the adhesive force was improved not by the macro-level unevenness but by the presence of the nanoporous layer. In addition, Fig. 9 is shown by a higher magnification than that in Fig. 8.

### <Embodiment 3>

A test piece was made in the same fashion as in the embodiment 1 except that the laser processing condition was changed into one where the beam spot size: 25 µm and the laser light intensity: 1.4×10¹¹ W/cm².

### <Embodiment 4>

A test piece was made in the same fashion as in the embodiment 1 except that the laser processing condition was changed into one where the laser scanning speed: 0.5 mm/sec in the longitudinal direction (X) and the machining speed: 400 mm²/sec.

### <Embodiment 5>

A test piece was made in the same fashion as in the embodiment 1 except that the laser processing condition was changed into one where the laser scanning speed: 0.1 mm/sec in the longitudinal direction (X) and the machining speed: 80 mm²/sec.

### <Comparative Example 1>

As is the case with the embodiment 1, only the cleaning treatment was performed using the UV ozone generator without performing the laser processing and then a test piece was made.

### [Evaluation of Adhesive Force of Test Piece]

Using a SAICAS (Surface and Interface Cutting Analysis System) measuring device made by DAIPLA WINTES CO., LTD., the adhesive force between metal and resin was evaluated. First, a cutter performs a vertical movement (0.1 µm/sec) and a horizontal movement (2 µm/sec) and then cuts the resin coating and thereafter the cutter performs only the horizontal movement (2 µm/sec) immediately before the cutter reaches the metal acting as a base material, thus determining the adhesive force from the horizontal force in the process of peeling the resin coating.

**[Table 1]**

| | Embodiment 1 | Embodiment 2 | Embodiment 3 | Embodiment 4 | Embodiment 5 | Comparative Example 1 |
|---|---|---|---|---|---|---|
| Type of Metal | Copper | | | | | |
| Pretreatment | UV 180sec | | | | | |
| Pulse Energy (µJ) | 90 | | | | | - |
| Pulse Repetiton Frequency(kHz) | 20 | | | | | - |
| Central Wavelength(nm) | 515 | | | | | - |
| Pulse Width (psec) | 0.9 | | | | | - |
| Beam Spot Size (µm) | 66 | 300 | 25 | 66 | 66 | - |
| Laser Intensity(W/cm²) | 2.9×10¹² | 5.7×10¹¹ | 1.4×10¹¹ | 2.9×10¹² | 2.9×10¹² | |
| X Scan Speed(mm/sec) | 1 | | | 0.5 | 0.1 | - |
| Y Scan Speed(mm/sec) | 800 | | | | | - |
| Maching Speed (mm²/sec) | 800 | 800 | 800 | 400 | 80 | - |
| Rz(µm) | 3.9 | 2.0 | 5.3 | 6.6 | 5.6 | 2.4 |
| Nanoporous Layer on Metal Surface | Present | Present | Present | Present | Present | Absent |
| Thickness of Nanoporous Layer(nm) | 100-200 | about 50 | 100-200 | 200-400 | 400-1100 | - |
| Cavity Formation in Nanoporous Layer | Formed | Formed | Formed | Formed | Formed | Not Formed |
| Cavity Size (nm) | 20-80 | 20-40 | 20-100 | 20 | 20-100 | - |
| Adhesive Force (N/m) | 2348 | 2291 | 2207 | 2151 | 2096 | 1550 |

As is clear from a Table 1, the laser intensity was changed according to the embodiment 1 to the embodiment 3 and then the laser processing was performed, and as a result, the adhesive forces of 2,207 N/m or more were obtained. Further, even when changing the machining speed to perform the laser processing as shown in the embodiment 4 to the embodiment 5, the adhesive values of 2,096 N/m or more could be verified. As described above, in comparison with the comparative example 1 where the laser processing was omitted, it could be verified in the embodiment 1 to the embodiment 5 that a clearly high adhesive property has developed.

Furthermore, as shown in the Table 1, as a result of observing a cross section subjected to an ion milling process in the metal-resin interface of the metal-resin composite in each embodiment, the nanoporous layers of 50 nm to 1,100 nm in thickness could be verified. Moreover, it was verified that the 20 to 100 nm cavities were formed in the vicinity of the surface of the metal.

From the above result, the adhesive property between metal and resin could be enhanced by regulating the laser intensity and the laser machining speed and besides an excellent resin surface after the baking treatment could be obtained.

As described above, the preferred embodiments of the present invention are described. The present invention is, however, not limited to these embodiments. Those skilled in the art can clearly make the various alternative embodiments and various modifications within the scope of the technical idea disclosed in the present invention. Therefore, it can be understood that even these alternative embodiments and modifications justifiably fall within the technical scope of the present invention.

### [Reference Sign List]

- 1,1a: copper-resin composite body
- 3: metal
- 5: nanoporous layer
- 7: resin
- 9: cavity
- 11: insulated copper wire
- 13: metal wire
- 15: nanoporous layer
- 17: insulating coating
- 21: flat cable
- 23: conductor
- 25: nanoporous layer
- 27: resin layer
- 29: resin layer
- 31: beam spot

## Claims

1. A copper -resin composite body comprising;
a metal made of copper or a copper alloy, and
a resin adhering to the metal via a nanoporous layer formed on the metal.

2. The copper-resin composite body according to claim 1, wherein the nanoporous layer contains copper-oxide particles of 5 nm to 500 nm in average particle diameter.

3. The copper-resin composite body according to claim 1 or claim 2, wherein the resin is thermosetting resin containing at least one selected from a group including polyimide, polyamide-imide, polyesterimide, polyetherimide, polyimide hydantoin-modified polyester, formal, polyurethane, polyester, polyvinylformal, epoxy resin, phenol resin, and polyhydantoin.

4. The copper-resin composite body according to any one of claim 1 to claim 3, wherein a ten-point average roughness Rz of the metal is 20 µm or less in an interface between the metal and the resin.

5. The copper-resin composite body according to any one of claim 1 to claim 4, wherein cavities of 10 nm to 500 nm in diameter are included in the vicinity of a surface of the metal in the interface between the metal and the resin.

6. The copper-resin composite body according to any one of claim 1 to claim 5, wherein the copper-resin composite body is any one of an insulated copper wire, a flat cable, a surface-treated copper foil, a copper-clad laminate, a battery electrode, and a surface-treated coper band.

7. A method for producing a copper-resin composite body, comprising:
a process for forming a copper-oxide nanoporous layer on a surface of a metal made of copper or a copper alloy by irradiating the surface of the metal with laser, and
a process for forming resin on the copper-oxide nanoporous layer.
